# EUROPEAN PATENT APPLICATION

(11) **EP 4 418 310 A1**
(43) Date of publication of application: **21.08.2024**
(21) Application number: 22881053.7
(22) Date of filing: 12.10.2022
(51) Int. Cl.: H01L 21/60, H01L 21/52, H01L 21/683

(54) **RECEPTOR SUBSTRATE , METHOD FOR MANUFACTURING RECEPTOR SUBSTRATE, TRANSFER METHOD, LED PANEL MANUFACTURING METHOD, AND STAMPER**

(30) Priority: 14.10.2021 JP 2021168927
(71) Applicant: SHIN-ETSU CHEMICAL CO., LTD., Tokyo 1000005 (JP)
(72) Inventor: YAMAOKA, Hiroshi, Yokohamashi, Kanagawa 234-0053 (JP); KURATA, Masami, Yokohamashi, Kanagawa 234-0053 (JP); USAMI, Taketo, Yokohamashi, Kanagawa 234-0053 (JP); OGAWA, Yoshinori, Tokyo 100-0005 (JP); KONDO, Kazunori, Tokyo 100-0005 (JP)
(74) Representative: Meissner Bolte Partnerschaft mbB
(86) International application number: PCT/JP2022/038067
(87) International publication number: WO 2023/063358

(57) **Abstract**

To provide a receptor substrate that can enhance a success rate of picking up objects to be transferred during transfer by using a stamper, a method for manufacturing the receptor substrate, a transfer method using the receptor substrate, and a method for manufacturing an LED panel.

On the receptor substrate, a plurality of objects to be transferred onto another substrate by using a stamper are disposed. The receptor substrate includes a plurality of sections in each of which a group of the objects to be transferred that are to be simultaneously in a single transfer operation of the stamper are disposed, and a non-disposed region, in which the objects to be transferred are not disposed, at an outside of the section. In the receptor substrate, each of the plurality of sections is surrounded by the non-disposed region.

## Description

### TECHNICAL FIELD

The present invention relates to a receptor substrate, a method for manufacturing the receptor substrate, a transfer method, a method for manufacturing an LED panel, and a stamper.

### BACKGROUND ART

In recent years, nitride semiconductor optical devices have become used for a backlight of a liquid crystal display and a display for signage. Since a large number of optical devices are used at a time for these applications, a high-speed transfer technique has been demanded. As the high-speed transfer technique, collective transfer by a stamping method using a stamper has been generally performed, and transfer of one thousand to tens of thousands of optical devices at once has become possible.

A large number of optical devices are produced, for example, on a sapphire substrate by a semiconductor process. For producing a 4-inch display substrate with LEDs each having a 100 um or less square, called micro LED, millions of micro LEDs are required. The micro LED, which is a minute device with a length of several tens of micro-meters, is utilized after being separated from the sapphire substrate, which is an epitaxial substrate.

The separation is generally performed by attaching a support substrate as a donor precursor substrate to optical devices arranged on the sapphire substrate, and separating the optical devices from the sapphire substrate by laser lift-off. Thereby, it is possible to obtain a donor substrate on the surface of which a large number of optical devices are disposed.

Such a method can be used not only in relation to optical devices, but also for manufacturing a donor substrate on the surface of which a plurality of objects to be transferred such as minute semiconductor devices are disposed.

The objects to be transferred on the donor substrate may be transferred, for example, onto a receptor substrate such that the arrangement corresponding to a circuit substrate of a manufactured product is obtained. Then, from the receptor substrate, the objects to be transferred may be transferred onto another substrate such as the circuit substrate of the manufactured product by the stamping method.

For example, Patent Document 1 proposes a method in which an object to be transferred on a donor substrate are accurately transferred onto a receptor substrate by using laser irradiation.

### CITATION LIST

### PATENT LITERATURE

Patent Document 1: JP 2020-4478 A

### SUMMARY OF INVENTION

### TECHNICAL PROBLEM

Conventionally, during transfer of objects to be transferred from a receptor substrate to another substrate by the stamping method, inconvenience such as failing to pick up a part of the objects, or mistakenly picking up a device adjacent to the objects to be transferred has occurred in some cases. By the above inconvenience, the productivity of a product including a plurality of objects to be transferred has been lowered.

The present invention was made for solving the above problem, and has for its object to provide a receptor substrate that can enhance a success rate of picking up objects to be transferred during transfer by using a stamper, a method for manufacturing the receptor substrate, a transfer method using the receptor substrate, a method for manufacturing an LED panel, and a stamper.

### SOLUTION TO PROBLEM

For solving the above problem, the present invention provides a receptor substrate on which a plurality of objects to be transferred onto another substrate by using a stamper are disposed, the receptor substrate comprising:
a plurality of sections in each of which a group of the objects to be transferred that are to be simultaneously transferred in a single transfer operation of the stamper are disposed; and
a non-disposed region, in which the objects to be transferred are not disposed, at an outside of the section, wherein
each of the plurality of sections is surrounded by the non-disposed region.

The receptor substrate of the present invention has a plurality of sections in each of which a group of objects to be transferred that are to be simultaneously transferred in a single transfer operation of the stamper are disposed; and thus, the transfer can be performed in each of the sections and it is not necessary to transfer all the objects to be transferred at once by using a big stamper. As a result, it is possible to prevent pick-up deficiency caused by warpage in the surface direction of a stamper or receptor substrate used.

Moreover, in the receptor substrate of the present invention, each of the sections is surrounded by a non-disposed region in which the objects to be transferred are not disposed; and thus, it is possible to prevent mistakenly picking up a device disposed in an adjacent section in a single transfer operation of the stamper.

Consequently, according to the receptor substrate of the present invention, it is possible to enhance the success rate of picking up objects to be transferred, and thereby improving the productivity of a product including the objects to be transferred.

For example, the objects to be transferred may be micro LEDs or semiconductor chips.

The objects to be transferred are not particularly limited, and may be micro LEDs or semiconductor chips, for example.

Further, the present invention provides a method for manufacturing a receptor substrate on which a plurality of objects to be transferred onto another substrate by using a stamper are disposed, the method comprising:
a step of providing a donor substrate including the objects to be transferred, and a receptor precursor substrate, and
a step of obtaining a receptor substrate by transferring the objects to be transferred from the donor substrate onto the receptor precursor substrate by laser lift-off, wherein
in the step of obtaining the receptor substrate, the objects to be transferred are transferred by the laser lift-off such that a plurality of sections in each of which a group of the objects to be transferred that are to be simultaneously transferred in a single transfer operation of the stamper disposed are formed, and a non-disposed region in which the objects to be transferred are not disposed is formed at an outside of the section, and each of the plurality of sections is surrounded by the non-disposed region on the receptor precursor substrate.

According to such a method for manufacturing a receptor substrate, the inventive receptor substrate which can improve the success rate of picking up objects to be transferred can be manufactured, resulting in improving the productivity of a product including the objects to be transferred.

Further, the present invention provides a method for transferring a plurality of objects to be transferred from the inventive receptor substrate onto another substrate by using a stamper, the method comprising:
a stamping step of transferring the group of the objects to be transferred from at least one of the plurality of sections in the receptor substrate onto the another substrate simultaneously by using the stamper in a single transfer operation in each of the sections.

According to such a transfer method, the receptor substrate of the present invention is used, and thus the success rate of picking up objects to be transferred can be enhanced. Consequently, excellent transfer efficiency can be achieved.

Further, the present invention provides a method for manufacturing an LED panel, the method comprising:
a step of providing the inventive receptor substrate, in which the objects to be transferred are micro LEDs;
a step of providing an LED panel substrate; and
a step of transferring the micro LEDs, which are in the group of the objects to be transferred, from at least one of the plurality of sections in the receptor substrate onto the LED panel substrate simultaneously by using a stamper in a single transfer operation in each of the sections.

According to such a method for manufacturing an LED panel, the transfer is performed by using the receptor substrate of the present invention, and thus the success rate of picking up micro LEDs can be enhanced. As a result, the LED panel can be manufactured with high productivity.

Further, the present invention provides a stamper provided with a stamper head on one side of a substrate, wherein
a region in which the stamper head is not provided on the one side of the substrate has a region subjected to anti-sticking treatment.

Such a stamper includes the region subjected to anti-sticking treatment, and thus can prevent unintentional pickup at a section adjacent to the section to be transferred even when the stamper contacts with a part of the adjacent section, thereby the success rate of picking up the objects to be transferred can be enhanced. Moreover, such a stamper having subjected to anti-sticking treatment is particularly effective for repairing (retransfer of objects to be transferred onto a part of a substrate, in which other objects to be transferred are disposed and defective objects to be transferred have been removed), not only used for pickup in each of the section.

The anti-sticking treatment may be, for example, formation of an anti-sticking film.

The anti-sticking treatment is not particularly limited, and may be, for example, formation of an anti-sticking film.

The anti-sticking film may be a fluorine resin film or a metal film.

The anti-sticking film is not particularly limited, and may be, for example, a fluorine resin film or a metal film.

For example, the side of the stamper head to pick up objects to be transferred may have a protrusion.

By virtue of having a protrusion at the side of the stamper head to pick up objects to be transferred, and more excellent picking up property can be exhibited.

In this case, the protrusions are preferably disposed in a matrix manner.

By having the protrusions disposed in a matrix manner, more stable pickup can be achieved.

The size of the protrusion is preferably such that a diameter of a circumscribed circle circumscribing the protrusion is 0.5 to 1.5 times as large as a diameter of a circumscribed circle circumscribing an object to be transferred.

Within the range described above, transfer can be performed more accurately.

The side of the stamper head to pick up objects to be transferred may have an adhesive layer.

The stamper of the present invention may achieve pickup by an adhesive layer.

Further, the side of the stamper head to pick up objects to be transferred may be made of an adhesive.

The stamper of the present invention may achieve pickup by an adhesive.

The stamper head may be formed of a silicone resin.

The stamper head may be, for example, formed of a silicone resin.

The stamper of the present invention is used for, for example, repairing processing.

As described above, the stamper of the present invention is particularly effective for repairing.

### ADVANTAGEOUS EFFECTS OF INVENTION

As described above, according to the inventive receptor substrate, the success rate of picking up objects to be transferred can be enhanced, and thus, the productivity of a product including the objects to be transferred can be improved.

Furthermore, according to the method for manufacturing the receptor substrate of the present invention, the inventive receptor substrate of the present invention capable of enhancing the success rate of picking up objects to be transferred, results in improving the productivity of a product including the objects to be transferred can be produced.

In addition, the transfer method of the present invention can enhance the success rate of picking up objects to be transferred, and thereby achieving excellent transfer efficiency.

Moreover, by the method for manufacturing an LED panel of the present invention, the LED panel can be manufactured with high productivity.

Furthermore, the stamper of the present invention can enhance the success rate of picking up objects to be transferred.

### BRIEF DESCRIPTION OF DRAWINGS

FIG. 1 is a schematic plan view showing an example of a receptor substrate of the present invention;
FIG. 2 is a schematic flow diagram showing an example of a transfer method using an example of the receptor substrate of the present invention;
FIG. 3 is a schematic flow diagram showing a part of a method for manufacturing an LED panel using an example of the receptor substrate of the present invention;
FIG. 4 is a schematic flow diagram showing a part of an example of a method for manufacturing the receptor substrate of the present invention;
FIG. 5 is a schematic flow diagram showing another part of the example of the method for manufacturing the receptor substrate of the present invention;
FIG. 6 is a schematic flow diagram showing another part of the example of the method for manufacturing the receptor substrate of the present invention;
FIG. 7 is a schematic flow diagram showing another part of the example of the method for manufacturing the receptor substrate of the present invention;
FIG. 8 is a schematic flow diagram showing another part of the example of the method for manufacturing the receptor substrate of the present invention;
FIG. 9 is a schematic flow diagram showing another part of the example of the method for manufacturing the receptor substrate of the present invention; and
FIG. 10 is a schematic flow diagram showing another part of the example of the method for manufacturing the receptor substrate of the present invention.

### DESCRIPTION OF EMBODIMENTS

As described above, it has been demanded to develop a receptor substrate that can enhance the success rate of picking up objects to be transferred during transfer by using a stamper.

The present inventors made intensive investigation for solving the above problem. As a result, they found that a receptor substrate having a plurality of sections in each of which a group of objects to be transferred that are to be simultaneously transferred in a single transfer operation of a stamper are disposed, and each of the plurality of sections is surrounded by a non-disposed region in which objects to be transferred are not disposed can prevent failing to pick up a part of the objects to be transferred, or picking up a device adjacent to the objects to be transferred by mistake. Based this finding, the present invention was completed.

That is, the present invention is a receptor substrate on which a plurality of objects to be transferred onto another substrate by using a stamper are disposed, the receptor substrate comprising:
a plurality of sections in each of which a group of the objects to be transferred that are to be simultaneously transferred in a single transfer operation of the stamper are disposed; and
a non-disposed region, in which the objects to be transferred are not disposed, at an outside of the section, wherein
each of the plurality of sections is surrounded by the non-disposed region.

Further, the present invention is a method for manufacturing a receptor substrate on which a plurality of objects to be transferred onto another substrate by using a stamper are disposed, the method comprising:
a step of providing a donor substrate including the objects to be transferred, and a receptor precursor substrate, and
a step of obtaining a receptor substrate by transferring the objects to be transferred from the donor substrate onto the receptor precursor substrate by laser lift-off, wherein
in the step of obtaining the receptor substrate, the objects to be transferred are transferred by the laser lift-off such that a plurality of sections in each of which a group of the objects to be transferred that are to be simultaneously transferred in a single transfer operation of the stamper disposed are formed, and a non-disposed region in which the objects to be transferred are not disposed is formed at an outside of the section, and each of the plurality of sections is surrounded by the non-disposed region on the receptor precursor substrate.

Further, the present invention is a method for transferring a plurality of objects to be transferred from the inventive receptor substrate onto another substrate by using a stamper, the method comprising:
a stamping step of transferring the group of the objects to be transferred from at least one of the plurality of sections in the receptor substrate onto the another substrate simultaneously by using the stamper in a single transfer operation in each of the sections.

Further, the present invention is a method for manufacturing an LED panel, the method comprising:
a step of providing the inventive receptor substrate, in which the objects to be transferred are micro LEDs;
a step of providing an LED panel substrate; and
a step of transferring the micro LEDs, which are in the group of the objects to be transferred, from at least one of the plurality of sections in the receptor substrate onto the LED panel substrate simultaneously by using a stamper in a single transfer operation in each of the sections.

Further, the present invention is a stamper provided with a stamper head on one side of a substrate, wherein
a region in which the stamper head is not provided on the one side of the substrate has a region subjected to anti-sticking treatment.

Hereinafter, the present invention will be described in detail, but the present invention is not limited thereto.

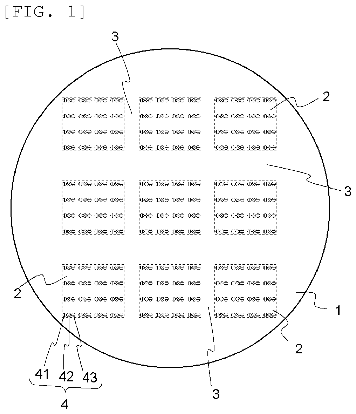

FIG. 1 shows a schematic plan view of the receptor substrate of the present invention.

On the receptor substrate 1 of FIG. 1, a plurality of objects to be transferred 4 are disposed. The receptor substrate 1 of FIG. 1 has a plurality of sections 2 in each of which a group of the objects to be transferred 4 are disposed, and has a non-disposed region 3, in which the objects to be transferred 4 are not disposed, at outside of the sections 2. Each of the plurality of sections 2 is surrounded by the non-disposed region 3.

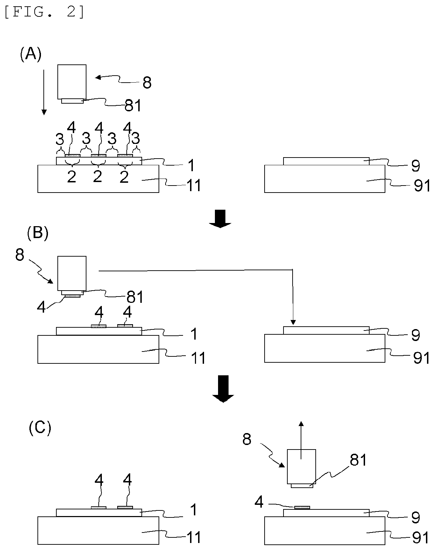

An example of a transfer method using such a receptor substrate 1 will be described referring to FIG. 2.

First, as shown in FIG. 2(A), the receptor substrate 1 is fixed on a receptor stage 11, and another substrate 9 is fixed on a substrate stage 91.

Next, from one of the plurality of sections 2 on the receptor substrate 1, the group of the objects to be transferred 4 disposed thereon are transferred simultaneously in a single transfer operation by using a stamper 8 to the another substrate 9.

Specifically, as shown by an arrow in FIG. 2(A), the stamper 8 provided with a stamper head 81 at a lower end thereof is lowered, and the stamper head 81 is brought into contact with the group of the objects to be transferred 4 disposed in one of the sections 2. Thereby, as shown in FIG. 2(B), the stamper 8 can pick up the group of the objects to be transferred 4 in one section. The stamper 8 moves onto the another substrate 9 as shown by an arrow in FIG. 2(B), and moves upward 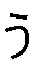 while leaving behind the group of the objects to be transferred 4 on the another substrate 9, as shown in FIG. 2(C).

The transfer as described above is performed from at least one section in each of the sections.

When using a big stamper to pick up all the objects to be transferred at once, warpage is generated on a picking up side of the stamper head. Influence of the warpage is great, and some of the objects to be transferred cannot be picked up. On the other hand, on the receptor substrate 1 of the present invention, the group of the objects to be transferred 4 that are to be transferred simultaneously in a single transfer operation of the stamper 8 are disposed in each of the plurality of sections 2. Thus, it is not necessary to use a big stamper that picks up all the objects to be transferred 4 on the receptor substrate 1 at once. By using the receptor substrate 1 of the present invention, a stamper provided with the stamper head 81 having a size corresponding to the size of each of the sections 2 can be used. Thus, there is no warpage problem of a picking up side of the stamper head 81, and therefore, the group of the objects to be transferred 4 in one of the sections 2 can be picked up uniformly without being left behind. As a result, although the number of times of stamping increases, the success rate of picking up can be enhanced as a consequence. In addition, even when the receptor substrate has warpage, by picking up objects in each of the sections as described above, the influence of warpage on the receptor substrate can be reduced.

Further, in the receptor substrate 1 of the present invention, each of the plurality of sections 2 is surrounded by the non-disposed region 3. Thus, when the stamper 8 picks up the objects to be transferred 4 from one of the sections 2 as shown in FIG. 2(B), objects to be transferred 4 disposed in the adjacent section 2 can be prevented from attaching the stamper 8. Thereby, it is possible to prevent picking up a device adjacent to the target objects to be transferred 4 by mistake.

According to the receptor substrate 1 of the present invention, as described hereinabove, it is possible to prevent failing to pick up a part of the objects to be transferred 4, or picking up a device adjacent to the objects to be transferred 4 by mistake. As a result, the success rate of picking up the objects to be transferred can be enhanced.

The objects to be transferred 4 are not particularly limited, and may be, for example, micro LEDs or semiconductor chips.

FIG. 1 schematically shows the example in which the plurality of objects to be transferred 4 including a red micro-light emitting diode (LED) 41, a green micro LED 42, and a blue micro LED 43 are disposed. In FIG. 1, for the purpose of explanation, micro LEDs 41 to 43 are shown in a visually recognizable manner. In actuality, however, micro LEDs are so densely integrated that they are invisible to the naked eye.

In each of the plurality of sections 2 shown in FIG. 1, for example, micro LEDs 41 to 43 that are mountable to a backplane of one smartwatch as they are may be arranged at pixel pitches as one group of the objects to be transferred 4. In the example shown in FIG. 1, micro LEDs 41 to 43 for nine smartwatches are disposed on the receptor substrate 1 at pixel pitches.

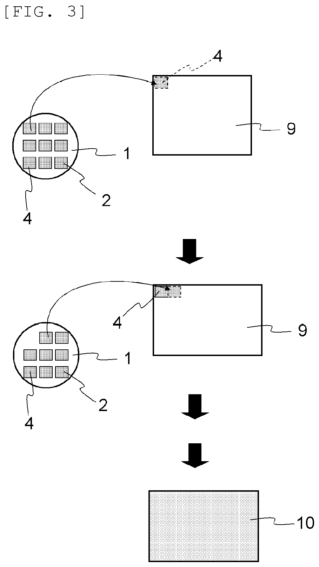

Then, by using the receptor substrate 1, as shown in FIG. 3, it is also possible to transfer and lay micro LEDs, which are the objects to be transferred 4, from at least one of the sections 2 in the receptor substrate 1 onto an LED panel substrate 9 as the another substrate 9 in each of the sections 2, thereby manufacturing one LED panel 10. Herein, examples of the LED panel substrate 9 include a backplane.

By thus transferring the objects to be transferred 4 using the receptor substrate 1 of the present invention, not only a small product such as a smartwatch, but also a large device such as a large LED panel can be manufactured with high productivity. In particular, in the case of manufacturing a large device, by using a plurality of the receptor substrates 1 of the present invention in accordance with the size of the device and performing successive transfer by using a stamper, the large device can be efficiently manufactured without changing the size of the stamper 8 used. That is, the receptor substrate 1 of the present invention can easily adapt to changes in size of a product, and can be easily applied to manufacturing of a large device.

In the application to a large device, a plurality of stampers may be simultaneously used. Also in this case, transfer of the objects to be transferred 4 from at least one of the plurality of sections 2 are simultaneously performed in a single transfer operation of one stamper in each of the sections 2.

The size of the device to which the present invention can be applied is not particularly limited. For example, a device having a circuit substrate with a size of 25 mm² or more and 100 m² or less can be manufactured.

It should be noted that in the example shown in FIG. 1, the red micro LED 41, green micro LED 42, and blue micro LED 43 are disposed in each of the sections 2; but the receptor substrate 1 on which micro LEDs are disposed may have only one or two colors in these three colors of LEDs in each of the sections 2.

The shape of the section is preferably quadrilateral as shown in FIG. 1. The productivity and application easiness to a large device can be improved with the quadrilateral shape. Additionally, in the case when one device is manufactured from one section, the shape of the section may be circular, elliptical, and polygonal other than quadrilateral, not only limited to quadrilateral. Thereby, design possibility of the device can be extended.

The width of the non-disposed region 3 is not particularly limited, and preferably 10 µm or more and 50 mm or less. In another aspect, the width of the non-disposed region 3 is preferably 0.025 times or more and 0.1 times or less of the width of each of the sections 2. In the case of the receptor substrate 1 in which the red micro LED 41, green micro LED 42, and blue micro LED 43 are disposed, the width of the non-disposed region 3 is preferably two times or more and 100 times or less of the shortest distance among the LEDs.

It is preferable that there is no object to be transferred in the non-disposed region. However, a small number of objects to be transferred may be present unintentionally due to manufacturing accuracy, or a small number of objects to be transferred or dummy objects to be transferred may be present for the purpose of relaxing stress, or the like. In such case, a total area of such objects to be transferred is preferably 10% or less, more preferably 1% or less, particularly preferably 0.1% or less, extremely preferably 0.01% or less, and most preferably 0.001% or less of the area of the non-disposed region.

The body of the receptor substrate 1 (a receptor precursor substrate 6 described below) is not particularly limited, and a substrate generally used as a receptor substrate can be used. For example, the receptor precursor substrate is a glass substrate such as a synthetic quartz glass substrate, and may be a glass substrate the surface of which has an adhesive layer. Adhesive strength of the adhesive layer is preferably such that the objects to be transferred can be picked up by using a stamper in the subsequent step.

Also, the stamper 8 is not particularly limited, and one generally used as the stamper 8 can be used. A region that is not provided with a stamper head in the side of the stamper provided with the stamper head is preferably subjected to anti-sticking treatment with an anti-sticking film such as a fluorine resin film or a metal film. The metal film can be formed by, for example, vapor deposition, sputtering, and plating. The anti-sticking film as above can prevent unintentional pickup at a section adjacent to the section to be transferred even when the stamper contacts with a part of the adjacent section. Moreover, the stamper subjected to the anti-sticking treatment as above is particularly effective for repairing (retransfer of objects to be transferred onto a part of a substrate, in which other objects to be transferred are disposed and defective objects to be transferred have been removed), not only used for pickup in every section. When the stamper subjected to the anti-sticking treatment is used for repairing, the stamper head can deal with various sizes of repairing, such as a size corresponding to one to three objects to be transferred and a size corresponding to the section. The side of the stamper head to pick up objects to be transferred may have an adhesive layer, or may be made of an adhesive, for example. Moreover, the side of the stamper head to pick up objects to be transferred may have a protrusion. By providing a protrusion, the picking up property can be improved. In particular, when one object to be transferred is picked up, by using a stamper head having one protrusion, transfer can be performed with high accuracy. The size of the protrusion is not particularly restricted, and is preferably such that a diameter of a circumscribed circle circumscribing the protrusion is 0.5 to 1.5 times, more preferably 0.7 to 1.3 times, and particularly preferably 0.9 to 1.1 times as large as a diameter of a circumscribed circle circumscribing the object to be transferred. Within this range, transfer can be performed more accurately.

Such a stamper can be manufactured by, for example, forming a stamper head with a silicone resin or the like on a substrate having a shape of circular, elliptical, quadrilateral, and polygonal other than quadrilateral. The size of the stamper may change depending on the objects to be transferred or a process applied. The above substrate preferably has a length of the diameter (in case of circular), long diameter (in case of elliptical), or longest side (in case of quadrilateral, and polygonal other than quadrilateral) of 10 to 200 mm, and a thickness of 0.5 to 3 mm, because many objects to be transferred and processes can be dealt with. In addition, when the stamper is applied to a large number of objects to be transferred or large size of objects to be transferred, the substrate preferably has a length of 200 to 1000 mm, and a thickness of 0.5 to 6 mm. The stamper head is preferably smaller than the substrate, and preferably has a length shorter than the length of the substrate by about 2 to 20 mm, in view of stamper head formability and securing an effective area. The size of the protrusion is preferably such that the diameter of the circumscribed circle circumscribing the protrusion is 1 to 150 um, and a height of the protrusion is preferably 1 to 500 um. When a large number of protrusions are disposed on the stamper head, the protrusions are preferably disposed in a matrix manner. In that case, a protrusion may not be disposed in an outer periphery of the stamper head. Note that when the protrusions are disposed in a matrix manner, a pitch between the protrusions is preferably about 5 to 1000 µm.

The another substrate 9 is not limited to a product substrate such as an LED panel substrate, and may be another receptor precursor substrate for transferring the objects to be transferred 4 onto a product substrate.

The objects to be transferred 4 transferred from the receptor substrate 1 of the present invention can be connected to a circuit substrate by, for example, a flip-chip bonding method.

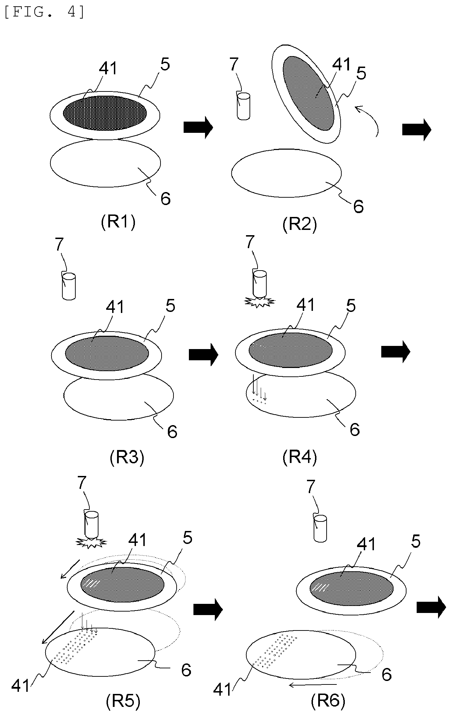

Next, an example of the method for manufacturing the receptor substrate 1 of the present invention will be described referring to FIG. 4 to FIG. 10. Note that the receptor substrate 1 of the present invention may also be manufactured by a method other than that described below.

First, as shown in FIG. 4 (R1), a receptor precursor substrate 6 and a donor substrate 5 on which a plurality of red micro LEDs 41 are disposed are provided. In FIG. 4 (R1), the red micro LEDs 41 are disposed on an upward side of the donor substrate 5.

Then, as shown in FIG. 4 (R2), the donor substrate 5 is turned over, and the side on which the red micro LEDs 41 are disposed is made opposed to the receptor precursor substrate 6 as shown in FIG. 4 (R3). A laser light source 7 is provided, and positioned.

Thereafter, as shown in FIG. 4 (R4), a line laser beam is emitted from the laser light source 7 toward the donor substrate 5. Line laser light of the laser beam flashes. The red micro LEDs 41 irradiated with the laser beam fly over to the receptor precursor substrate 6, and attach to a predetermined position of the receptor precursor substrate 6 as shown in FIG. 4 (R4). When transferring micro LEDs from a donor substrate onto a receptor substrate and pitches of the micro LEDs on the donor substrate and the receptor substrate are different from each other as described above, laser lift-off is preferably performed while, for example, spacing apart the donor substrate and the receptor substrate by a certain distance to keep them no-contact, and while changing the moving speed of the donor substrate and receptor substrate, instead of performing the laser lift-off by contacting the donor substrate and receptor substrate.

As shown in FIG. 4 (R5), by moving the receptor precursor substrate 6 and the donor substrate 5 with the laser light source 7 fixed, a plurality of the red micro LEDs 41 fly over to the receptor precursor substrate 6 successively in conjunction with flashes of the laser, and attach to a predetermined position on a pattern.

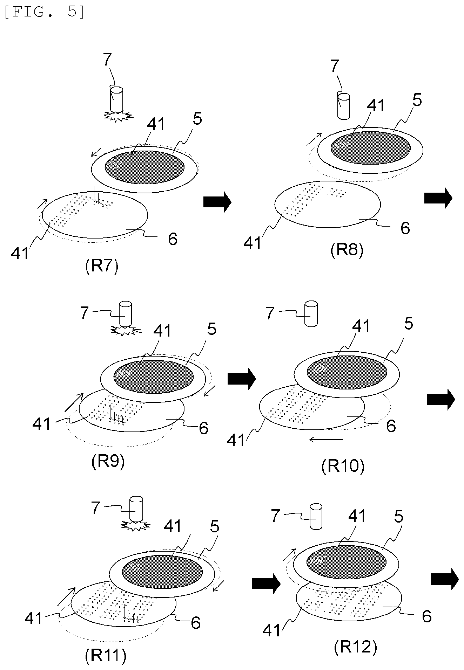

Then, as shown in FIG. 4 (R6), and FIG. 5 (R7) to FIG. 5 (R12), positioning and laser irradiation are repeated. Thereby, the plurality of the red micro LEDs 41 can be transferred onto the receptor precursor substrate 6 in a desired pattern.

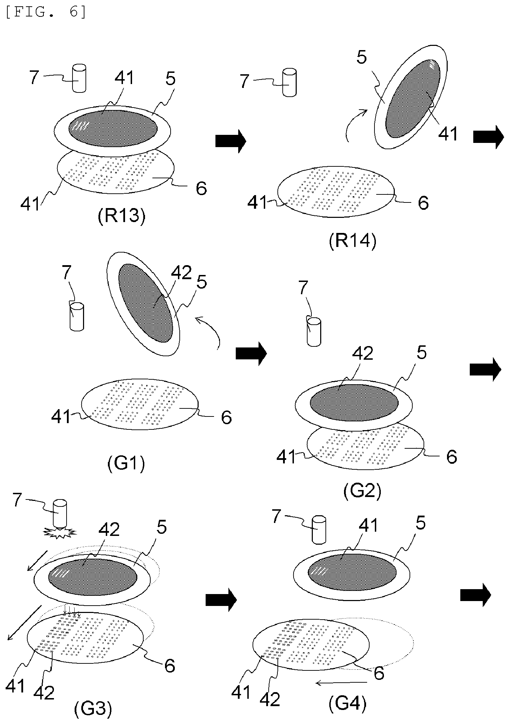

Subsequently, as shown in FIG. 6 (R13), the donor substrate and receptor precursor substrate are returned to the original position (FIG. 4 (R3)), and as shown in FIG. 6 (R14), the donor substrate 5 is taken out.

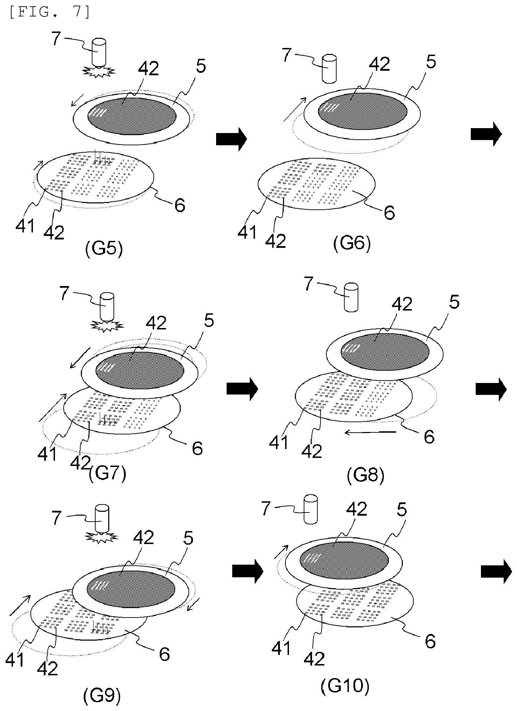

Subsequently, as shown in FIG. 6 (G1), the donor substrate 5 on which a plurality of green micro LEDs 42 are disposed is provided, and, as shown in FIG. 6 (G2) to (G4), and FIG. 7 (G5) to (G10), positioning and laser irradiation are repeated as in the case of the red micro LEDs 41. Thereby, the plurality of the green micro LEDs 42 can be transferred onto the receptor precursor substrate 6 in a desired pattern.

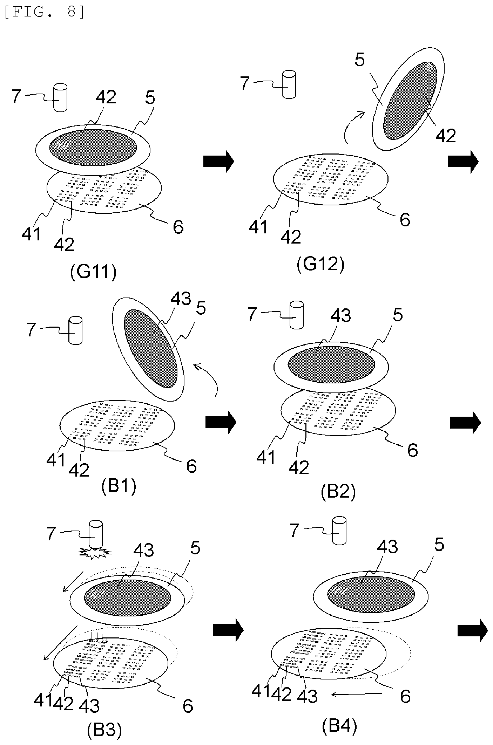

Next, as shown in FIG. 8 (G11), the donor substrate and receptor precursor substrate are returned to the original position (FIG. 6 (G2)), and as shown in FIG. 8 (G12), the donor substrate 5 is taken out.

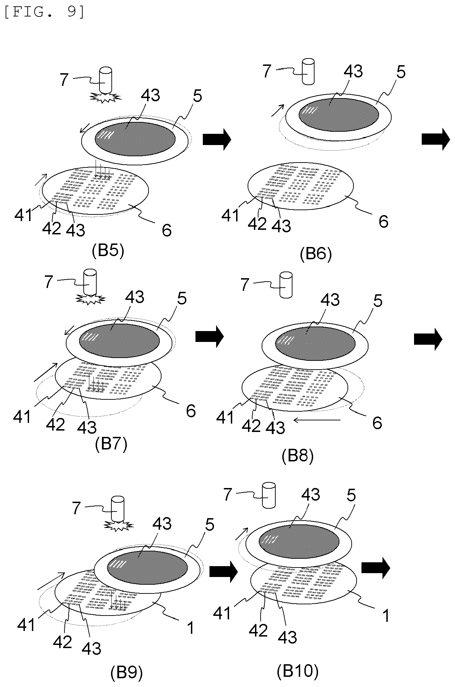

Then, as shown in FIG. 8 (B1), the donor substrate 5 on which a plurality of blue micro LEDs 43 are disposed is provided, and, as shown in FIG. 8 (B2) to (B4), and FIG. 9 (B5) to (B10), positioning and laser irradiation are repeated as in the case of the red micro LEDs 41. Thereby, the blue micro LEDs 43 can be transferred onto the receptor precursor substrate 6 in a desired pattern.

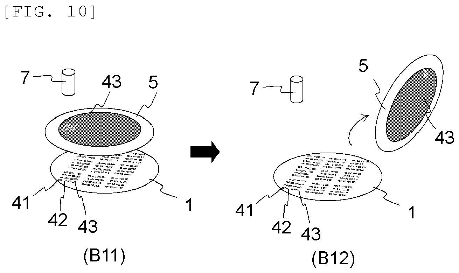

Subsequently, as shown in FIG. 10 (B11), the donor substrate and receptor precursor substrate are returned to the original position (FIG. 8 (B2)), and as shown in FIG. 10 (G12), the donor substrate 5 is taken out.

The positioning is performed such that a plurality of the sections 2 in which a group of micro LEDs 41 to 43 are disposed are formed, the non-disposed region 3 in which micro LEDs 41 to 43 are not disposed is formed at outside of the sections 2, and each of the plurality of sections 2 is surrounded by the non-disposed region 3 to perform transfer (selective laser lift-off) of the micro LEDs 41 to 43, and thereby the receptor substrate 1 of the present invention can be manufactured.

The donor substrate 5 and the light source 7 used are not particularly limited, and those generally used in laser lift-off can be used. Specifically, the donor substrate refers to a substrate (supply substrate) including objects to be transferred for laser lift-off. Examples thereof include a substrate that is similar to the receptor substrate mentioned above, and a glass substrate such as a synthetic quartz glass substrate, the surface of which has an abrasion layer such as a polyimide layer. The laser lift-off can be easily performed by having the abrasion layer.

From the viewpoint as the above supply substrate, the receptor substrate may be obtained by transferring objects to be transferred from a wafer on which micro LEDs or semiconductor chips are formed, in place of the donor substrate, to a receptor precursor substrate by laser lift-off.

It should be noted that the present invention is not limited to the above-described embodiments. The embodiments are just examples, and any examples that substantially have the same feature and demonstrate the same functions and effects as those in the technical concept disclosed in claims of the present invention are included in the technical scope of the present invention.

## Claims

1. A receptor substrate on which a plurality of objects to be transferred onto another substrate by using a stamper are disposed, the receptor substrate comprising:
a plurality of sections in each of which a group of the objects to be transferred that are to be simultaneously transferred in a single transfer operation of the stamper are disposed; and
a non-disposed region, in which the objects to be transferred are not disposed, at an outside of the section, wherein
each of the plurality of sections is surrounded by the non-disposed region.

2. The receptor substrate according to claim 1, wherein the objects to be transferred are micro LEDs or semiconductor chips.

3. A method for manufacturing a receptor substrate on which a plurality of objects to be transferred onto another substrate by using a stamper are disposed, the method comprising:
a step of providing a donor substrate including the objects to be transferred, and a receptor precursor substrate, and
a step of obtaining a receptor substrate by transferring the objects to be transferred from the donor substrate onto the receptor precursor substrate by laser lift-off, wherein
in the step of obtaining the receptor substrate, the objects to be transferred are transferred by the laser lift-off such that a plurality of sections in each of which a group of the objects to be transferred that are to be simultaneously transferred in a single transfer operation of the stamper disposed are formed, and a non-disposed region in which the objects to be transferred are not disposed is formed at an outside of the section, and each of the plurality of sections is surrounded by the non-disposed region on the receptor precursor substrate.

4. A method for transferring a plurality of objects to be transferred from the receptor substrate according to claim 1 onto another substrate by using a stamper, the method comprising:
a stamping step of transferring the group of the objects to be transferred from at least one of the plurality of sections in the receptor substrate onto the another substrate simultaneously by using the stamper in a single transfer operation in each of the sections.

5. A method for manufacturing an LED panel, the method comprising:
a step of providing the receptor substrate according to claim 1, in which the objects to be transferred are micro LEDs;
a step of providing an LED panel substrate; and
a step of transferring the micro LEDs, which are in the group of the objects to be transferred, from at least one of the plurality of sections in the receptor substrate onto the LED panel substrate simultaneously by using a stamper in a single transfer operation in each of the sections.

6. A stamper provided with a stamper head on one side of a substrate, wherein
a region in which the stamper head is not provided on the one side of the substrate has a region subjected to anti-sticking treatment.

7. The stamper according to claim 6, wherein the anti-sticking treatment is formation of an anti-sticking film.

8. The stamper according to claim 7, wherein the anti-sticking film is a fluorine resin film or a metal film.

9. The stamper according to claim 6, wherein a side of the stamper head to pick up the objects to be transferred has a protrusion.

10. The stamper according to claim 9, wherein the protrusions are disposed in a matrix manner.

11. The stamper according to claim 9, wherein a size of the protrusion is such that a diameter of a circumscribed circle circumscribing the protrusion is 0.5 to 1.5 times as large as a diameter of a circumscribed circle circumscribing an object to be transferred.

12. The stamper according to claim 6, wherein a side of the stamper head to pick up the objects to be transferred has an adhesive layer.

13. The stamper according to claim 6, wherein a side of the stamper head to pick up the objects to be transferred is made of an adhesive.

14. The stamper according to claim 6, wherein the stamper head is formed of a silicone resin.

15. The stamper according to any one of claims 6 to 14, which is used for repairing processing.
